# EUROPÄISCHE PATENTANMELDUNG

(11) **EP 0 730 342 A1**
(43) Veröffentlichungstag der Anmeldung: **04.09.1996**
(21) Anmeldenummer: 96102985.7
(22) Anmeldetag: 28.02.1996
(51) Int. Cl.: H03F 3/08, H03F 3/60

(54) **Schaltungsanordnung eines Ultra-Breitband Empfängers**

(30) Priorität: 01.03.1995 DE 19507133
(71) Anmelder: SIEMENS AKTIENGESELLSCHAFT, 80333 München (DE)
(72) Erfinder: Fischer, Uwe, Dipl.-Ing., 81479 München (DE)

(57) **Zusammenfassung**

Schaltungsanordnung eines Ultra-Breitband Empfängers in diskreter Bauweise mit mindestens einer mit einem Verstärkerelement gebildeten Verstärkerstufe, wobei das Verstärkerelement einer ersten Verstärkerstufe mit einer Gegenkopplungseinheit gebildet ausgebildet ist und die Gegenkopplungseinheit aus zwei Widerstandselementen und einer zwischen den Widerstandselementen angeordneten Kapazität gebildet ist.

## Beschreibung

Die Erfindung bezieht sich auf eine Schaltungsanordnung eines Ultra-Breitband Empfängers.

Ein Ultra-Breitband Empfänger ist z.B. aus der US-Patentschrift 5.010.588 bekannt. Diese Schaltungsanordnung, ein Hochimpedanz-Empfänger, weist jedoch den Nachteil auf, daß zu einer Gesamtlinearisierung des Frequenzgangs neben einer Vielzahl von Schaltungs-/Leitungs-Elementen zusätzlich am Schaltungsausgang ein die Dynamik des Ultra-Breitband Empfängers einschränkendes Hochpaßfilter benötigt wird. Desweiteren bringt die Schaltungsanordnung den Nachteil mit sich, daß bei einer speziell für ein geringes Rauschverhalten ausgelegten Dimensionierung der Empfängerschaltung diese nur eine geringe Dynamik aufweist. Diese Empfängerschaltung muß zudem auf den jeweiligen Anwendungsfall entweder mit einer "hohen Eingangsempfindlichkeit" oder auf eine "hohe zulässige optische Eingangsleistung" speziell ausgebildet und optimiert werden. Aus Elektronic Letters, 1993, Vol.29, No 5, Seite 492, 493 von M. Neuhäuser, H.M. Rein, H. Wenz und A. Felder ist eine weitere Ultra-Breitband Empfängerschaltung, eine in einem Baustein integrierte Transimpedanz-Schaltung bekannt. Diese Transimpedanz-Schaltung weist eine hohe Dynamik bei gleichzeitigem niedrigen Rauschverhalten auf. Diese Vorteile lassen sich jedoch nur bei einer integrierten Schaltungungsanordnung realisieren. Ein Nachteil dieser angeführten Schaltung ist es, daß die bei diesem Schaltungstyp vorgesehene Gegenkopplung bedingt durch die Signalverzögerung des Verstärkerelementes leicht zu einer Selbsterregung führt, wobei die Signalgegenkopplung am oberen Ende des Übertragungsbereichs zur Signalmitkopplung wird.

In diskreter Bauweise läßt sich die Transimpedanz-Schaltung daher nicht mit einer für einen Ultra-Breitband Empfänger erforderlichen Bandbreite realisieren.

Die Aufgabe der Erfindung ist es, eine diskrete Schaltungsanordnung eines Ultra-Breitband Empfängers mit geringen Rauscheigenschaften und hoher Dynamik anzugeben.

Die Aufgabe wird durch die Merkmale des Patentanspruchs 1 gelöst.

Die Erfindung bringt neben dem Vorteil, daß gleichzeitig eine gewünschte Bandbreite von größer als 10 GHz mit einer hohen Frequenzganglinearität (ab ca. 50 KHz), eine große Dynamik bei einem gleichzeitig geringem Rauschverhalten erreicht wird.
Bei der erfindungsgemäßen Ausgestaltung der Schaltungsanordnung ergibt sich außerdem eine Einsparung von einem einen Hochpaß bildenden Filterelement am Schaltungsausgang des Ultra-Breitband Empfängers. Desweiteren bringt die Schaltungsanordnung den weiteren Vorteil mit sich, daß zur Herstellung eines diskreten Schaltungsaufbaus kommerzielle Bauteile verwendbar sind.

Die Erfindung bringt den weiteren Vorteil mit sich, daß in ein geeignetes Mikrowellengehäuse eingebaute Empfangselemente für höchste Datenraten als Schnittstelle am Eingang des Ultra-Breitband Empfängers verwendet werden können.

In einer weiteren Ausgestaltung der Erfindung wird der Gegenkopplungswiderstand in zwei Teilgegenkopplungswiderstände aufgeteilt. Diese Teilgegenkopplungswiderstände sind jeweils an den Enden einer Gegenkopplungsschleife am Verstärkerelement der Schaltungsanordnung angeordnet. Dies bringt den Vorteil mit sich, daß die bei hohen Frequenzen auftretenden Stichleitungs-Filtereffekte vermieden werden.

Ein weiterer Vorteil der Erfindung besteht darin, daß eine Umsetzung der Schaltung auf hochdielektrischem Substrat unter Verwendung geschichteter Bauteile möglich ist.

Weitere Besonderheiten der Erfindung werden aus den nachfolgenden Erläuterungen anhand eines Ausführungsbeispiels ersichtlich.

Am Schaltungseingang E der Schaltungsanordnung erfolgt beispielsweise die Signaleinspeisung über ein optoelektrisches Wandlerelement.
Die im Ausführungsbeispiel gezeigte Schaltungsanordnung ist ein aus einer Eingangsverstärkerstufe EV und einer Ausgangsverstärkerstufe AV gebildeter Ultra-Breitband Empfänger. Das optoelektronische Wandlerelement, eine Photodiode P, ist an ihrer einen Elektrode zum einen über einen Kondensator CE und zum anderen über einen als Strombegrenzung für die Photodiode P wirkenden Widerstand R bias verbunden.
Die zweite Elektrode der Photodiode P ist mit dem Eingang G des Verstärkerelementes T1 der Eingangsverstärkerstufe EV, einem Feldeffekttransistor, und mit einer in Reihe dazu liegenden aus einem den Arbeitspunkt des Feldeffekttransistors T1 einstellenden Widerstand Rg1 und eine zur Ablockung von Gleichspannungs-Signalanteilen in Reihe dazu geschalteter Kondensator Cg1 geschaltet. Der Widerstand Rg1 bildet einen Teil des Arbeitswiderstandes der Photodiode P. Der Gate- und Drainanschluß des Verstärkerelementes T1 in der Eingangsverstärkerstufe EV ist mit einer Reihenschaltung bestehend aus mindestens zwei Widerstandselementen Rf1, Rf2 sowie einer zwischen den beiden Widerstandselementen Rf1, Rf2 angeordneten Kapazität C1 verbunden.
Der Source-Anschluß des Verstärkerelementes T1 der Eingangsstufe EV ist an einem dem Massepotential entsprechenden Betriebspotential angeschlossen. Am Drainanschluß des Verstärkerelementes T1 der Eingangsstufe EV ist ein Arbeitswiderstand Rd1 sowie in Reihe dazu ein Kondensator Cd1 angeordnet. Spannungspotentialanschlüsse SpE, Sp1, Sp1' zum Betreiben der Photodiode P sowie des Verstärkerelementes T1 in der Eingangsverstärkerstufe EV sind jeweils an den zwischen den die Gleichspannungsteile ablockenden Kapazitäten Cg1, Cd1 sowie dem Widerstand Rbias, Rg und Rd1 angeordnet. Zur Gleichspannungs-Potentialtrennung CT zwischen der Eingangsverstärkerstufe EV und der Ausgangsverstärkerstufe AV ist ein Kondensator CT angeordnet. Die der Eingangsverstärkerstufe EV nachgeordneten Ausgangsverstärkerstufe AV weist ein weiteres als spannungsgesteuerte Stromquelle ausgebildetes aktives Verstärkerelement T2 auf. Am Gate- und am Drainanschluß des Verstärkerelementes T2 der Ausgangsverstärkerstufe AV ist jeweils eine Reihenschaltung Rg2, Cg2; Rd2, Cd2, gebildet aus einem Widerstandselement Rg2, Rd2 und einer Kapazität Cg2, Cd2 angeordnet. Das Kapazitätselement Cg2, Cd2 ist dabei mit einer Anschlußseite mit einem dem Betriebspotential entsprechenden Spannungspotential verbunden. Zwischen dem Widerstandselement Rg2 (Rd2) und der Kapazität Cg2 (Cd2) der Reihenschaltung wird jeweils das für das Verstärkerelement T2 notwendige Spannungspotential zur Einstellung des Arbeitspunktes des aktives Elementes in der Ausgangsverstärkerstufe AV angelegt.

Zwischen den oben aufgeführten "diskreten" Schaltungselementen sind jeweils transformierende Leitungselemente LE zur jeweiligen Anpassung der einzelnen diskreten Schaltungselemente in die Schaltungsanordnung integriert. Die Anpassung und Abstimmung der Schaltungselemente der gesamten Schaltungsanordnung des Ultra-Breitband Empfängers erfolgt unter anderem durch Variation der einzelnen transformierenden Leitungselemente LE in ihrer Breite und/oder Länge.

Bei der erfindungsgemäßen Schaltung wird zunächst von einer Hochimpedanz-Schaltung mit einem ohmschen Arbeitswiderstand Rg1 in der Eingangsverstärkerstufe EV am Gateanschluß des Verstärkerelementes T1 der Eingangsverstärkereinheit EV ausgegangen. Je nach Dimensionierung des Widerstandes Rg1 weist diese Hochimpedanz-Schaltung entweder ein vergleichsweises hohes Rauschen (Rg klein) oder eine geringe Dynamik (Rg groß) auf.

Erfindungsgemäß ist die Hochimpedanz-Schaltung zusätzlich mit einem neu eingefügten Rückkopplungsglied beim Verstärkerelement T1 der Eingangsverstärkerstufe EV ausgebildet. Diese Rückkopplung, eine Reihenschaltung gebildet aus zwei durch ein kapazitives Element C1 unterbrochene Widerstandselemente Rf1, Rf2 ist dabei so dimensioniert, daß keine Selbsterregung des Verstärkerelementes T1 eintritt.
Ausgangspunkt ist eine auf geringes Eingangsrauschen und eine auf eine hohe Eingangsempfindlichkeit hin ausgelegte Hochimpedanz-Schaltung mit einem ohmschen Arbeitswiderstand Rg1 im Eingang der Schaltungsanordnung (Rg1 relativ groß). Am Verstärkerelement in der Eingangsverstärkerstufe EV wird ein Gegenkopplungswiderstand Rf1 und Rf2 hinzugefügt. Der gesamte Gegenkopplungswiderstand Rf1, Rf2 ist dabei so gewählt, daß die sich ergebende Verstärkung einer offenen Schleife im Frequenzbereich einer kritischen Phasendrehung soweit reduziert ist (i.e. kleiner als 1), so daß eine Selbsterregung vermieden wird.
Dies gestattet zum einen, daß der bei der Hochimpedanz-Schaltung übliche RC-Hochpaß-Entzerrer am Ausgang der Schaltungsanordnung entfällt und zum anderen wird gegenüber der ursprünglichen reinen Hochimpedanz-Schaltung ein niedriges Eingangsrauschen mit einer signifikanten Verbesserung der Dynamik erzielt. Dies ist auf die Eigenschaft der Schaltungsanordnung zurückzuführen, daß bereits eine Gegenkopplung der oben beschriebenen Art ausreicht, um den auftretenden Pegelanstieg herkömmlicher Hochimpedanz-Schaltungen fast vollständig zu linearisieren.

Die erreichte Linearisierung des Frequenzganges ist so weitgehend, daß wie oben bereits angegeben auf den sonst üblichen RC-Hochpaß-Entzerrer innerhalb des Empfangsverstärkers oder an dessen Ausgang verzichtet werden kann.

Die Restentzerrung wird durch einen Gesamtabgleich der in der Empfänger-Schaltungsanordnung enthaltenen transformierenden Leitungs- und/oder Bauelemente erzielt.

Durch die relativ hohen Laufzeiten und damit schnell mit der Frequenz zunehmenden Phasendrehungen in einem diskreten Aufbau, ist nur eine geringe Gegenkopplung beim Verstärkerelement T1 der Eingangsverstärkerstufe EV möglich. Eine insgesamt geringe Gegenkopplung wird durch die relativ hochohmigen Widerstände Rf1 und Rf2 bewirkt. Da sowohl die Übertragungsfunktion F(w), des Verstärkerelementes T1 mit den Gatewiderständen Rbias, Rg1 und Drainwiderstand Rd1 als auch die Übertragungsfunktion B(w) der Gegenkopplungsschleife aufgrund unvermeidlicher Tiefpaßwirkung jedoch zu tiefen Frequenzen hin ansteigen, ist dort die Gegenkopplungswirkung stärker. Die insgesamt schwache Gegenkopplung der Schaltungsanordnung reicht dazu aus, die gewünschte Dynamikverbesserung zu erreichen. Rg1 wird dabei so ausgelegt, daß die Schaltung das gewünschte Rauschverhalten zeigt.

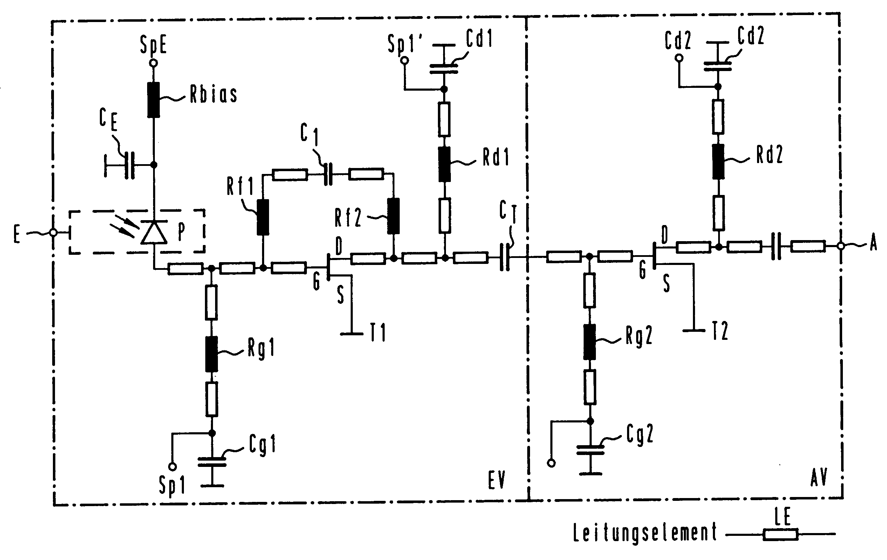

## Patentansprüche

1. Schaltungsanordnung eines Ultra-Breitband Empfängers in diskreter Bauweise mit mindestens einer mit einem Verstärkerelement (T1, T2) gebildeten Verstärkerstufe (EV, AV), wobei an einem ersten Anschluß (G) des Verstärkerelementes (T1) ein Arbeitspunkt bestimmendes Widerstandselement (Rg), an einem zweiten Anschluß (D) des Verstärkerelemetes (T1) ein Arbeitswiderstand (Rd1) sowie ein Koppelkondensator (CT) angeordnet sind, mit einem T-förmigen Leitungselement zur frequenzmäßigen Impedanzanpassung zwischen dem Arbeitswiderstand (Rd1), dem zweiten Anschluß (D) des Verstärkerelementes und dem Koppelkondensator (C1),
**dadurch gekennzeichnet,**
daß das Verstärkerelement (T1) der ersten Verstärkerstufe (V1) mit einer Gegenkopplungseinheit (Rf1, C1, Rf2) zwischen dem ersten und zweiten Anschluß (G, D) des Verstärkerelementes (T1) ausgebildet ist.

2. Schaltungsanordnung nach Anspruch 1,
**dadurch gekennzeichnet,**
daß die Gegenkopplungseinheit (Rf1, C1, Rf2) aus einer Reihenschaltung, die aus mindestens zwei Widerstandselementen (Rf1, Rf2) und einem zwischen diesen angeordneten kapazitiven Element (C1) sowie jeweils zwischen den Widerstandselementen (Rf1, Rf2) und dem kapazitiven Element ein Leitungselement angeordnet ist.

3. Schaltungsanordnung nach Anspruch 2,
**dadurch gekennzeichnet,**
daß ein Anschlußende der Widerstandselemente (Rf1, Rf2) unmittelbar an die Eingangs- und Ausgangsleitung des Verstärkerelementes (T1) angeschlossen ist.

4. Schaltungsanordnung nach einem der vorhergehenden Ansprüche,
**dadurch gekennzeichnet,.**
daß das Verstärkerelement (T1, T2) ein Galliumarsenit Feldeffekttransistor ist.

5. Schaltungsanordnung nach Anspruch 1,
**dadurch gekennzeichnet,**
daß am Gateanschluß sowie am Drainanschluß des Feldeffektransistors (T1, T2) mindestens ein Leitungselement (LEn) angeordnet ist, daß der Sourceanschluß mit einem dem Massepotential entsprechenden Betriebspotential verbunden ist, daß unmittelbar nach den Leitungselementen (LEn) die Gegenkopplungswiderstände (Rf1, Rf2) angeordnet sind.

6. Schaltungsanordnung nach Anspruch 1,
**dadurch gekennzeichnet,**
daß jeweils ein T-förmiges Leitungselement (LE) zur frequenzmäßigen Impedanzanpassung der Verstärkerstufen (V1, V2) am Eingang des ersten Verstärkerelementes (T1, T2) angeordnet ist.
